# EUROPÄISCHE PATENTSCHRIFT

(11) **EP 1 844 342 B1**
(45) Veröffentlichungstag und Bekanntmachung des Hinweises auf die Patenterteilung: **01.07.2020**
(21) Anmeldenummer: 06700504.1
(22) Anmeldetag: 10.01.2006
(51) Int. Cl.: G01R 31/28, H01L 21/00

(54) **VERFAHREN UND VORRICHTUNG ZUM TESTEN VON HALBLEITERWAFERN MITTELS EINER TEMPERIERBAREN AUFSPANNEINRICHTUNG**
METHOD AND DEVICE FOR TESTING SEMICONDUCTOR WAFERS USING A CHUCK DEVICE WHOSE TEMPERATURE CAN BE REGULATED
PROCEDE ET SYSTEME POUR TESTER DES PLAQUETTES DE SEMI-CONDUCTEUR AU MOYEN D'UN DISPOSITIF DE FIXATION A TEMPERATURE REGLABLE

(30) Priorität: 10.01.2005 DE 102005001163
(43) Veröffentlichungstag der Anmeldung: 17.10.2007
(73) Patentinhaber: ERS electronic GmbH, 82110 Germering (DE)
(72) Erfinder: Reitinger, Erich, 80636 München (DE)
(74) Vertreter: Isarpatent
(86) Internationale Anmeldenummer: PCT/EP2006/000142
(87) Internationale Veröffentlichungsnummer: WO 2006/072598

(56) Entgegenhaltungen:
- EP-A2- 0 993 243
- US-A- 5 775 416
- US-A- 5 977 785
- US-A1- 2002 017 916
- US-A1- 2002 062 954

## Beschreibung

Die vorliegende Erfindung betrifft ein Verfahren und eine Vorrichtung zum Testen von Halbleiterwafern mittles einer temperierbaren Aufspanneinrichtung.

Bekannterweise werden Testmessungen an Halbleiterwafern typischerweise in einem Temperaturbereich zwischen -60°C und +400°C durchgeführt. Zur Temperierung wird ein Halbleiterwafer auf einen Probertisch bzw. eine Aufspanneinrichtung gelegt, der entsprechend der Soll-Temperatur gekühlt und/oder beheizt wird.

Dabei ist einerseits darauf zu achten, dass die Temperatur des Halbleiterwafers nicht unter den Taupunkt des umgebenden gasförmigen Mediums gerät, da sonst eine Kondensation von Feuchtigkeit auf der Halbleiterwaferoberfläche bzw. eine Vereisung auftritt, welche die Testmessungen behindert bzw. unmöglich macht.

Andererseits tritt bei Testmessungen mit hoher Chipleistung das Problem auf, dass der Halbleiterwafer sich lokal auf der Vorderseite im Bereich des Stromflusses über die Temperatur der mit der Aufspanneinrichtung in Kontakt befindlichen Rückseite erwärmt, weil aufgrund des endlichen Wärmeübergangswiderstandes zwischen Halbleiterwafer und Aufspanneinrichtung die Wärmeabfuhr verzögert ist. Typischerweise erhält man bei elektrischen Leistungen von über 100 W eine lokale Temperaturdifferenz von ca. 90 K zwischen Vorderseite des Halbleiterwafers und Auflageseite der Aufspanneinrichtung. Diese Temperaturdifferenz stört die Testmessung, welche ja gerade die isothermen elektrischen Eigenschaften der im Halbleiterwafer integrierten Schaltungen angeben soll. Gleichzeitig können bei höheren Leistungen die Chips über eine maximal erlaubte Temperatur erwärmt werden, was die Gefahr eines elektrischen Ausfalls mit sich bringt.

Fig. 2 zeigt eine schematische Querschnittsansicht einer aus der US 5 010 296 bekannten Vorrichtung zum Testen von Halbleiterwafern mittels einer temperierbaren Aufspanneinrichtung.

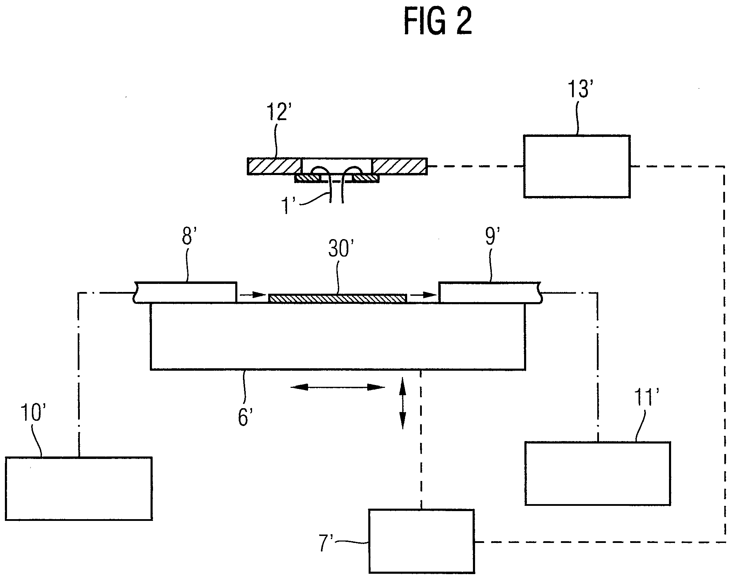

In Figur 2 bezeichnet Bezugszeichen 6' eine temperierbare Aufspanneinrichtung. Die Aufspanneinrichtung 6' ist mit einer Antriebseinrichtung 7' verbunden, welche eine Bewegung in Höhenrichtung und der Ebene veranlassen kann. Oberhalb der Aufspanneinrichtung 6' vorgesehen ist eine Sondenkarte 12', welche Sonden 1', beispielsweise in Form dünner Nadeln, aufweist, die dazu verwendet werden, integrierte Schaltungen auf einem Halbleiterwafer 30' zu kontaktieren und elektrische Messungen daran durchzuführen.

Bezugszeichen 13' bezeichnet eine Testereinrichtung, mittels der die Sonden 1' gemäß vorgegebener Testprogramme ansteuerbar sind. Ebenfalls ansteuerbar durch die Testereinrichtung 13' ist die Steuereinrichtung 7', um bestimmte integrierte Schaltungen des Halbleiterwafers 30' in Verbindung mit den Sonden 1' zu bringen.

Eine Gaszuführungseinrichtung 8', welche mit einer Gasversorgungseinrichtung 10' verbunden ist, ist auf der einen Seite der Aufspanneinrichtung 6' vorgesehen.

Auf der gegenüberliegenden Seite der Aufspanneinrichtung 6' ist eine Saugleitungseinrichtung 9' vorgesehen, die wiederum mit einer Saugeinrichtung 11' verbunden ist. Die Gaszuführungseinrichtung 8' und die Saugleitungseinrichtung 9' haben eine relativ flache Querschnittsgestalt, so dass Gas gleichmäßig über die gesamte Oberfläche des Halbleiterwafers 30' gespült werden kann. Die Gasspülung bei dieser bekannten Halbleiterwafertestvorrichtung dient zum Abtransport von Kontaminationspartikeln, die durch äußere Einflüsse oder unter dem Einfluss der Sonden 1' auf der Oberfläche des Halbleiterwafers abgelagert werden.

Aus Elektronik, Produktion und Prüftechnik, Juli/August 1982, Seiten 485 bis 487, Positionieren und Kontaktieren von Wafern, ist der Aufbau von Sondenkarten zum Testen von Halbleiterwafern bekannt.

Die US 2002/0062954 A1 offenbart ein Verfahren und eine Vorrichtung zum Testen von Halbleiterwafern mittels einer temperierbaren Aufspanneinrichtung deren Temperatur mit Hilfe einer Vielzahl von Temperatursensoren unter Verwendung einer Heizung in der Aufspanneinrichtung sowie einer fluidbasierten Heiz-/ Kühleinrichtung eingestellt wird.

Die EP 0 438 957 B1 offenbart eine Prüfvorrichtung für Halbleiterwafer, wobei an einer Aufspanneinrichtung eine Vielzahl von Temperatursensoren angebracht ist, die eine entsprechende Temperaturverteilung auf der Aufspannoberfläche erfassen.

Die EP 0 511 928 B1 offenbart eine Aufspanneinrichtung mit einer Vielzahl von Labyrinthkanälen, durch die ein Fluid zur Temperierung der Aufspanneinrichtung geleitet wird. Durch den labyrinthförmigen Aufbau werden eine hohe Kühlleistung und eine homogene Temperaturverteilung erzielt.

Die US 5 977 785 offenbart ein Verfahren und eine Vorrichtung zum Testen von Halbleiterwafern mittels einer temperierbaren Aufspanneinrichtung mit einer fluidbasierten Heiz-/Kühleinrichtung, wobei die Temperatur eines zu testenden Chips beim Testen erfasst wird und basierend auf dem Erfassungsergebnis eine Driftkorrektur der Steuerung der Heiz-/ Kühleinrichtung vorgenommen wird. Als Alternative Heizeinrichtungen nennt die US 5 977 785 resistive und induktive elektrische Heizeinrichtungen.

Die US 5 084 671 offenbart ein weiteres Verfahren und eine weitere Vorrichtung zum Testen von Halbleiterwafern mittels einer temperierbaren Aufspanneinrichtung mit einer fluidbasierten Kühleinrichtung und einer elektrischen Heizeinrichtung.

Es ist Aufgabe der vorliegenden Erfindung, ein Verfahren und eine Vorrichtung zum Testen von Halbleiterwafern mittels einer temperierbaren Aufspanneinrichtung anzugeben, welche eine Konditionierung des Halbleiterwafers ermöglichen.

Das erfindungsgemässe Verfahren mit den Merkmalen des Anspruchs 1 bzw. die entsprechende Vorrichtung nach Anspruch 6 weisen gegenüber dem bekannten Lösungsansatz den Vorteil auf, dass selbst bei hoher elektrischer Leistung nur eine sehr geringe Temperaturdifferenz zwischen Vorderseite des Halbleiterwafers und der Auflageseite des Chucks auftritt. Die der vorliegenden Erfindung zugrundeliegende Idee besteht darin, dass ein Temperieren der Aufspanneinrichtung mittels einer Heizeinrichtung mit einer vorgegebenen Heizleistung und einer Kühleinrichtung mit einer vorgegebenen Kühlleistung auf eine vorbestimmte Messtemperatur erfolgt, wobei die Heizleistung wesentlich größer als eine vorgegebene Testleistung ist. Beim Testen des Halbleiterwafers durch Einprägen der Testleistung von einer Testvorrichtung erfolgt ein Reduzieren der Heizleistung um den Betrag der Testleistung während des Testens bei im wesentlichen konstanter Kühlleistung.

Dies hat den Vorteil eines sehr schnellen Ansprechens der temperierbaren Aufspanneinrichtung als Reaktion auf die Zuführung der Testleistung.

In den Unteransprüchen finden sich vorteilhafte Weiterbildungen und Verbesserungen des betreffenden Gegenstandes der Erfindung.

Ein Ausführungsbeispiel der Erfindung ist in den Zeichnungen dargestellt und in der nachfolgenden Beschreibung näher erläutert.

Es zeigen:
- Fig. 1: eine schematische Darstellung einer Ausführungsform der erfindungsgemässen Vorrichtung zum Testen von Halbleiterwafern mittels einer temperierbaren Aufspanneinrichtung; und
- Fig. 2: eine schematische Querschnittsansicht einer aus der US 5 010 296 bekannten Vorrichtung zum Testen von Halbleiterwafern mittels einer Sondenkarte.

In den Figuren bezeichnen gleiche Bezugszeichen gleiche oder funktionsgleiche Bestandteile.

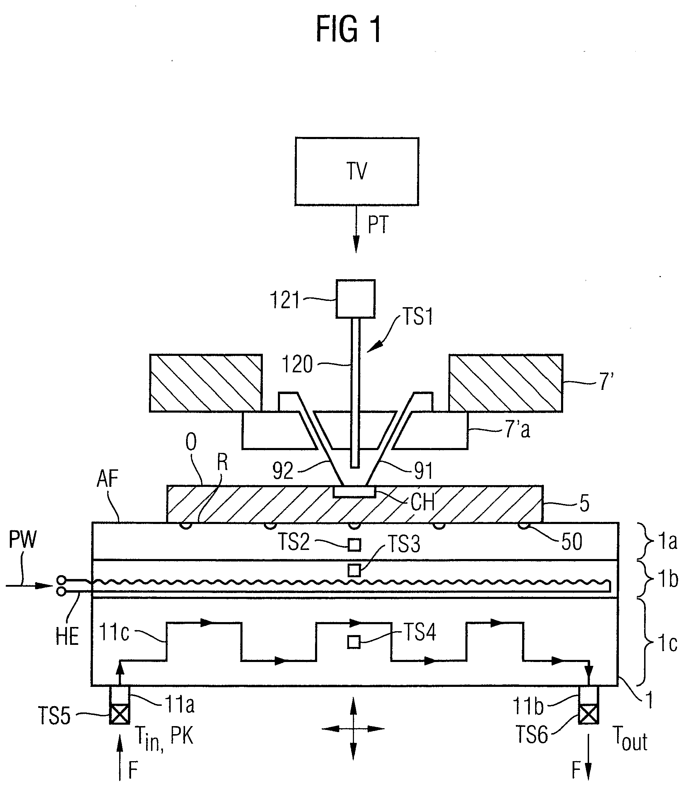

Fig. 1 zeigt eine schematische Darstellungen einer Ausführungsform der erfindungsgemässen Vorrichtung zum Testen von Halbleiterwafern mittels einer temperierbaren Aufspanneinrichtung.

In Figur 1 bezeichnet Bezugszeichen 1 eine temperierbare, in Höhenrichtung und innerhalb der Ebene verfahrbare temperierbare Aufspanneinrichtung.

Die Aufspanneinrichtung 1 weist einen oberen Bereich 1a auf, welcher mit Vakuumrillen 50 versehen ist. Auf dem oberen Bereich 1a der Aufspanneinrichtung 1 befindet sich ein Halbleiterwafer 5, der mit seiner Rückseite R die Auflageseite AF der Aufspanneinrichtung 1 kontaktiert.

In einem mittleren Bereich 1b der Aufspanneinrichtung 1 befindet sich eine elektrische Heizeinrichtung HE, welche durch Zuführung von elektrischer Leistung PW zum Aufheizen der Aufspanneinrichtung 1 vorgesehen ist.

Im unteren Bereich 1c der Aufspanneinrichtung 1 schließlich befindet sich ein labyrinthförmiges Kühlkanalsystem 11c, dem an einem Eingang 11a vorgekühltes Fluid F mit einer Eingangstemperatur Tin zugeführt wird und dem an einem Ausgang 11b dieses Fluid F mit erhöhter Temperatur Tout wieder entnommen wird. Mittels eines nicht dargestellten Temperierungssystems wird das Fluid F außerhalb der Aufspanneinrichtung 1 auf eine vorgegebene Solltemperatur gebracht.

Oberhalb des Halbleiterwafers 5 befindet sich eine plattenförmige Sondeneinrichtung 7', welche einen abgestuften Bereich 7'a aufweist, von dem ausgehend Sondennadeln 91, 92 auf einen Chipbereich CH auf der Vorderseite O des Halbleiterwafers 5 aufgesetzt sind.

Mittels einer Testvorrichtung TV werden elektrische Testsequenzen über die Sonden 91, 92 auf den Chipbereich CH übertragen, wobei eine Leistung PT in den Chipbereich CH eingespeist wird, die zur lokalen Erwärmung des Halbleiterchips 5 führt und weggekühlt werden muss, um eine gewünschtermaßen isotherme Testmessung durchzuführen.

Bei dieser erfindungsgemäßen Ausführungsform sind verschiedene Temperaturerfassungseinrichtungen TS1 bis TS6 vorgesehen. Eine erste Temperaturerfassungseinrichtung TS1 befindet sich an der Sondeneinrichtung 7' und weist ein Infrarotthermometer IR auf, welches einen IR-Lichtleiter 120 und eine Auswerteschaltung 121 umfasst.

Die Auswerteschaltung 121 erfasst mittels eines nicht dargestellten IR-Fotoleiters und einem nachgeschalteten Verstärker unmittelbar die Temperatur im Chipbereich CH.

Eine zweite Temperaturerfassungseinrichtung TS2 befindet sich im oberen Bereich 1a der Aufspanneinrichtung 1, eine dritte Temperaturerfassungseinrichtung TS3 im mittleren Bereich 1b der Aufspanneinrichtung 1 , eine vierte Temperaturerfassungseinrichtung TS4 im unteren Bereich 1c der Aufspanneinrichtung 1, eine fünfte Temperaturerfassungseinrichtung TS5 am Einlass 11a für das Fluid F, sowie eine sechste Temperaturerfassungseinrichtung TS6 am Ausgang 11b für das Fluid F. Mit den Temperaturerfassungseinrichtungen TS2 bis TS4 kann insbesondere ermittelt werden, ob sich die Aufspanneinrichtung 1 in thermischem Gleichgewicht befindet.

Vor der Testmessung erfolgt bei aufgelegtem Halbleiterwafer 5 und aufgesetzten Sonden 91 , 92 ein Temperieren der Aufspanneinrichtung 1 mittels der Heizeinrichtung HE mit einer vorgegebenen Heizleistung PW und der Kühleinrichtung 11a, 11b, 11c mit einer vorgegebenen Kühlleistung PK auf eine vorbestimmte Messtemperatur, z.B. -20°C, wobei die Heizleistung PW wesentlich grösser als eine vorgegebene Testleitung PT ist, z.B. PW = 1 kW, PT = 200 W.

Dann erfolgt ein Testen des Halbleiterwafers 5 durch Einprägen der Testleistung PT von der Testvorrichtung TV in den Chipbereich CH der Vorderseite O des Halbleiterwafers 5 mittels der Sonden 91, 92 der aufgesetzten Sondenkarte 7'.

Ausführungsgemäss wird die von der Heizleistung PW abzuziehende Testleistung PT unter Berücksichtigung der Signale der fünften und sechsten Temperaturerfassungseinrichtung TS5, TS6 vorgegeben, die die Eingangstemperatur Tin bzw. die Ausgangstemperatur Tout des der Aufspanneinrichtung 1 von der Kühleinrichtung 11a , 11b , 11c zur Kühlung gelieferten Fluids F während des Testens erfassen, denn dessen Temperaturerhöhung spiegelt ebenfalls die Testleistung PT wider.

Zusätzlich kann die von der Heizleistung PW abzuziehende Testleistung PT unter Berücksichtigung des Signals der ersten Temperaturerfassungseinrichtung TS1 vorgegeben werden, die die Temperatur des Chipbereichs CH während des Testens direkt kontaktlos erfasst.

Die Erfindung ist nicht auf gasförmige getrocknete Luft beschränkt, sondern prinzipiell auf beliebige Fluide anwendbar.

## Patentansprüche

1. Verfahren zum Testen von Halbleiterwafern (5) mittels einer temperierbaren Aufspanneinrichtung (1) mit den Schritten:
Temperieren der Aufspanneinrichtung (1) mittels einer elektrischen Heizeinrichtung (HE) mit einer vorgegebenen Heizleistung (PW) und einer Kühleinrichtung (11a, 11b, 11c), durch die zur Kühlung ein Fluid (F) geleitet wird, mit einer vorgegebenen Kühlleistung (PK) auf eine vorbestimmte Messtemperatur;
Auflegen der Rückseite (R) eines Halbleiterwafers (5) auf eine Auflageseite (AF) der temperierbaren Aufspanneinrichtung (1);
Aufsetzen einer Sondenkarte (7', 7'a) auf die Vorderseite (O) des Halbleiterwafers (5);
Testen des temperierten Halbleiterwafers (5) durch Einprägen der Testleistung (PT) von einer Testvorrichtung (TV) in einen Chipbereich (CH) der Vorderseite (O) des Halbleiterwafers (5) mittels Sonden (91, 92) der aufgesetzten Sondenkarte (7', 7'a); und
Erfassen einer die Testleistung (PT) widerspiegelnden Temperaturerhöhung des Fluids (F) beim Testen;
wobei die Heizleistung (PW) größer als eine vorgegebene Testleistung (PT) ist; und
wobei ein Reduzieren der Heizleistung (PW) durch Abziehen der Testleistung (PT) während des Testens bei im Wesentlichen konstanter Kühlleistung (PK) unter Berücksichtigung der beim Testen erfassten Temperaturerhöhung des Fluids (F) durchgeführt wird;
wobei die Temperaturerhöhung des Fluids (F) unter Berücksichtigung der Signale einer fünften und sechsten Temperaturerfassungseinrichtung (TS5, TS6) erfasst wird, die die Eingangstemperatur (Tin) und die Ausgangstemperatur (Tout) des der Aufspanneinrichtung (1) von der Kühleinrichtung (11a, 11b, 11c) zur Kühlung gelieferten Fluids (F) während des Testens erfassen.

2. Verfahren nach Anspruch 1, **dadurch gekennzeichnet, dass** die Heizleistung (PW) zusätzlich unter Berücksichtigung einer mittels des Signals einer ersten Temperaturerfassungseinrichtung (TS1) erfassten Temperaturerhöhung des Chipbereichs (CH) reduziert wird, wobei die erste Temperaturerfassungseinrichtung (TS1) die Temperatur des Chipbereichs (CH) während des Testens kontaktlos erfasst.

3. Verfahren nach Anspruch 2, **dadurch gekennzeichnet, dass** die erste Temperaturerfassungseinrichtung (TS1) ein Infrarotthermometer (120, 121) umfasst.

4. Verfahren nach einem der vorhergehenden Ansprüche, **dadurch gekennzeichnet, dass** die Aufspanneinrichtung (1) einen oberen Bereich (1a), einen mittleren Bereich (1b) und einen unteren Bereich (1c) aufweist, wobei der obere Bereich (1a) die Auflagefläche (AF) in Kontakt mit der Rückseite (R) des Halbleiterwafers (5), der mittlere Bereich (1b) die Heizeinrichtung (HE) und der untere Bereich (1c) die Kühleinrichtung (11a, 11b, 11c) aufweist.

5. Verfahren nach einem der vorhergehenden Ansprüche, **dadurch gekennzeichnet, dass** die Testleistung (PT) in der Größenordnung von einem bis einigen Hundert Watt und die Heizleistung (PW) in der Größenordnung von einem bis einigen Kilowatt liegt.

6. Vorrichtung zum Testen von Halbleiterwafern (5) mit einer temperierbaren Aufspanneinrichtung (1) mit:
einer Temperierungseinrichtung, die eingerichtet ist zum Temperieren der Aufspanneinrichtung (1) mittels einer elektrischen Heizeinrichtung (HE) mit einer vorgegebenen Heizleistung (PW) und einer Kühleinrichtung (11a, 11b, 11c), durch die zur Kühlung ein Fluid (F) leitbar ist, mit einer vorgegebenen Kühlleistung (PK), auf eine vorbestimmte Messtemperatur;
einer Testvorrichtung (TV) zum Testen des temperierten Halbleiterwafers (5) durch Einprägen einer Testleistung (PT) in einen Chipbereich (CH) der Vorderseite (O) des Halbleiterwafers (5) mittels Sonden (91, 92) einer Sondenkarte (7', 7'a), wobei die Heizleistung (PW) größer als eine vorgegebene Testleistung (PT) ist;
einer Temperaturerfassungseinrichtung, die eingerichtet ist, eine die Testleistung (PT) widerspiegelnde Temperaturerhöhung des Fluids (F) beim Testen zu erfassen;
wobei die Temperierungseinrichtung Mittel aufweist, so dass ein Reduzieren der Heizleistung (PW) durch Abziehen der Testleistung (PT) während des Testens bei im Wesentlichen konstanter Kühlleistung (PK) unter Berücksichtigung der beim Testen erfassten Temperaturerhöhung des Fluids (F) stattfindet; und
wobei eine fünfte und sechste Temperaturerfassungseinrichtung (TS5, TS6) vorgeshen ist zur Erfassung der Temperaturerhöhung des Fluids durch die Temperaturerfassungseinrichtung unter Berücksichtigung der Signale dieser fünften und sechsten Temperaturerfassungseinrichtung (TS5, TS6), die eingerichtet sind, die Eingangstemperatur (Tin) und die Ausgangstemperatur (Tout) des der Aufspanneinrichtung (1) zur Kühlung gelieferten Fluids (F) während des Testens zu erfassen.

7. Vorrichtung nach Anspruch 6, **dadurch gekennzeichnet, dass** die Temperierungseinrichtung eingerichtet ist die Heizleistung (PW) zusätzlich unter Berücksichtigung einer mittels des Signals einer ersten Temperaturerfassungseinrichtung (TS1) erfassten Temperaturerhöhung des Chipbereichs (CH) zu reduzieren, wobei die erste Temperaturerfassungseinrichtung (TS1) eingerichtet ist, die Temperatur des Chipbereichs (CH) während des Testens kontaktlos zu erfassen.

8. Vorrichtung nach Anspruch 7, **dadurch gekennzeichnet, dass** die erste Temperaturerfassungseinrichtung (TS1) ein Infrarotthermometer (120, 121) umfasst.

9. Vorrichtung nach einem der vorhergehenden Ansprüche 6 bis 8, **dadurch gekennzeichnet, dass** die Aufspanneinrichtung (1) einen oberen Bereich (1a), einen mittleren Bereich (1b) und einen unteren Bereich (1c) aufweist, wobei der obere Bereich (1a) die Auflagefläche (AF) in Kontakt mit der Rückseite (R) des Halbleiterwafers (5), der mittlere Bereich (1b) die Heizeinrichtung (HE) und der untere Bereich (1c) die Kühleinrichtung (11a, 11b, 11c) aufweist.

## Claims

1. Method for testing semiconductor wafers (5) using a temperature-controllable tensioning device (1), comprising the steps of:
temperature-controlling the tensioning device (1) to a predetermined measurement temperature, using an electrical heating device (HE) having a predetermined heating power (PW) and a cooling device (11a, 11b, 11c), through which a fluid (F) is passed for cooling, having a predetermined cooling power (PK);
laying the rear face (R) of a semiconductor wafer (5) on a support face (AF) of the temperature-controllable tensioning device (1);
positioning a probe card (7', 7'a) on the front face (O) of the semiconductor wafer (5);
testing the temperature-controlled semiconductor wafer (5) by applying the test power (PT) of a testing device (TV) to a chip region (CH) of the front face (O) of the semiconductor wafer (5) by means of probes (91, 92) of the positioned probe card (7', 7'a); and
detecting, during the testing, a temperature increase, which reflects the test power (PT), of the fluid (F);
wherein the heating power (PW) is greater than a predetermined test power (PT); and
wherein the heating power (PW) is reduced by withdrawing the test power (PT) during the testing at a substantially constant cooling power (PK) while taking account of the temperature increase, detected during the testing, of the fluid (F);
wherein the temperature increase of the fluid (F) is detected while taking account of the signals of a fifth and sixth temperature detection device (TS5, TS6), which detect, during the testing, the input temperature (Tin) and output temperature (Tout) of the fluid (F) supplied to the tensioning device (1) by the cooling device (11a, 11b, 11c) for cooling.

2. Method according to claim 1, **characterised in that** the heating power (PW) is additionally reduced while taking account of a temperature increase, detected using the signal of a first temperature detection device (TS1), of the chip region (CH), the first temperature detection device (TS1) detecting the temperature of the chip region (CH) contactlessly during the testing.

3. Method according to claim 2, **characterised in that** the first temperature detection device (TS1) comprises an infrared thermometer (120, 121).

4. Method according to any of the preceding claims, **characterised in that** the tensioning device (1) has an upper region (1a), a central region (1b) and a lower region (1c), the upper region (1a) having the support face (AF) in contact with the rear face (R) of the semiconductor wafer (5), the central region (1b) having the heating device (HE), and the lower region (1c) having the cooling device (11a, 11b, 11c).

5. Method according to any of the preceding claims, **characterised in that** the test power (PT) is of the order of magnitude of one to a few hundred watts and the heating power (PW) is of the order of magnitude of one to a few kilowatts.

6. Device for testing semiconductor waters (5) comprising a temperature-controllable tensioning device (1), comprising:
a temperature control device set up for temperature-controlling the tensioning device (1) to a predetermined measurement temperature, using an electrical heating device (HE) having a predetermined heating power (PW) and a cooling device (11a, 11b, 11c), through which a fluid (F) is passed for cooling, having a predetermined cooling power (PK);
a test device (TV) for testing the temperature-controlled semiconductor wafer (5) by applying a test power (PT) to a chip region (CH) of the front face (O) of the semiconductor wafer (5) by means of probes (91, 92) of a probe card (7', 7'a), the heating power (PW) being greater than a predetermined test power (PW);
a temperature detection device, which is set up for detecting, during the testing, a temperature increase, which reflects the test power (PT), of the fluid (F);
wherein the temperature device has means such that the heating power (PW) is reduced by withdrawing the test power (PT) during the testing at a substantially constant cooling power (PK) while taking account of the temperature increase, detected during the testing, of the fluid (F); and
wherein a fifth and sixth temperature detection device (TS5, TS6) are provided for detection of the temperature increase of the fluid by the temperature detection device while taking account of the signals of these fifth and sixth temperature detection devices (TS5, TS6), which are set up for detecting, during the testing, the input temperature (Tin) and output temperature (Tout) of the fluid (F) supplied to the tensioning device (1) for cooling.

7. Device according to claim 6, **characterised in that** the temperature control device is set up additionally to reduce the heating power (PW) while taking account of a temperature increase, detected using the signal of a first temperature detection device (TS1), of the chip region (CH), the first temperature detection device (TS1) detecting the temperature of the chip region (CH) contactlessly during the testing.

8. Device according to claim 7, **characterised in that** the first temperature detection device (TS1) comprises an infrared thermometer (120, 121).

9. Device according to any of preceding claims 6 to 8, **characterised in that** the tensioning device (1) has an upper region (1a), a central region (1b) and a lower region (1c), the upper region (1a) having the support face (AF) in contact with the rear face (R) of the semiconductor wafer (5), the central region (1b) having the heating device (HE), and the lower region (1c) having the cooling device (11a, 11b, 11c).

## Revendications

1. Procédé pour tester des plaquettes semi-conductrices (5) au moyen d'un dispositif de serrage thermorégulable (1), comprenant les étapes suivantes :
thermorégulation du dispositif de serrage (1) au moyen d'un dispositif de chauffage électrique (HE) ayant une puissance calorifique (PW) prédéfinie et d'un dispositif de refroidissement (11a, 11b, 11c) à travers lequel un fluide (F) est conduit pour le refroidissement, ayant une puissance frigorifique (PK) prédéfinie, à une température de mesure prédéterminée ;
application de la face arrière (R) d'une plaquette semi-conductrice (5) sur une face d'appui (AF) du dispositif de serrage thermorégulable (1) ;
pose d'une carte à pointes (7', 7'a) sur la face avant (O) de la plaquette semi-conductrice (5) ;
test de la plaquette semi-conductrice à température régulée (5) en appliquant la puissance de test (PT) d'un système de test (TV) dans une zone de puce (CH) de la face avant (O) de la plaquette semi-conductrice (5) au moyen de pointes (91, 92) de la carte à pointes (7', 7'a) posée sur celle-ci ; et détection d'une augmentation de température du fluide (F) reflétant la puissance de test (PT) lors du test ;
dans lequel la puissance calorifique (PW) est supérieure à une puissance de test (PT) prédéfinie ; et
dans lequel une réduction de la puissance calorifique (PW) est effectuée en soustrayant la puissance de test (PT) pendant le test à puissance de refroidissement (PK) sensiblement constante, en tenant compte de l'augmentation de température du fluide (F) détectée lors du test ;
dans lequel l'augmentation de température du fluide (F) est détectée en tenant compte des signaux d'un cinquième et d'un sixième dispositif de détection de température (TS5, TS6) qui détectent pendant le test la température d'entrée (Tin) et la température de sortie (Tout) du fluide (F) fourni au dispositif de serrage (1) par le dispositif de refroidissement (11a, 11b, 11c) pour le refroidissement.

2. Procédé selon la revendication 1, **caractérisé en ce que** la puissance calorifique (PW) est en outre réduite en tenant compte d'une augmentation de température de la zone de puce (CH) détectée au moyen du signal d'un premier dispositif de détection de température (TS1), le premier dispositif de détection de température (TS1) détectant la température de la zone de puce (CH) sans contact pendant le test.

3. Procédé selon la revendication 2, **caractérisé en ce que** le premier dispositif de détection de température (TS1) comprend un thermomètre infrarouge (120, 121).

4. Procédé selon l'une des revendications précédentes, **caractérisé en ce que** le dispositif de serrage (1) présente une zone supérieure (1a), une zone médiane (1b) et une zone inférieure (1c), la zone supérieure (1a) présentant la surface d'appui (AF) en contact avec la face arrière (R) de la plaquette semi-conductrice (5), la zone médiane (1b) présentant le dispositif de chauffage (HE) et la zone inférieure (1c) présentant le dispositif de refroidissement (11a, 11b, 11c).

5. Procédé selon l'une des revendications précédentes, **caractérisé en ce que** la puissance de test (PT) est de l'ordre de une à plusieurs centaines de watts et la puissance calorifique (PW) est de l'ordre de un à plusieurs kilowatts.

6. Système pour tester des plaquettes semi-conductrices (5) avec un dispositif de serrage thermorégulable (1), comprenant :
un dispositif de thermorégulation qui est prévu pour thermoréguler le dispositif de serrage (1) au moyen d'un dispositif de chauffage électrique (HE) ayant une puissance calorifique (PW) prédéfinie et d'un dispositif de refroidissement (11a, 11b, 11c), à travers lequel un fluide (F) peut être conduit pour le refroidissement, ayant une puissance frigorifique (PK) prédéfinie, à une température de mesure prédéterminée ;
un système de test (TV) pour tester la plaquette semi-conductrice thermorégulée (5) en appliquant une puissance de test (PT) dans une zone de puce (CH) de la face avant (O) de la plaquette semi-conductrice (5) au moyen de pointes (91, 92) d'une carte à pointes (7', 7'a), la puissance calorifique (PW) étant supérieure à une puissance de test (PT) prédéfinie ;
un dispositif de détection de température qui est conçu pour détecter une augmentation de température du fluide (F) reflétant la puissance de test (PT) lors du test ;
dans lequel le dispositif de thermorégulation présente des moyens permettant une réduction de la puissance calorifique (PW) en soustrayant la puissance de test (PT) pendant le test à puissance frigorifique (PK) sensiblement constante, en tenant compte de l'augmentation de température du fluide (F) détectée lors du test ; et
dans lequel un cinquième et un sixième dispositif de détection de température (TS5, TS6) sont prévus pour détecter l'augmentation de température du fluide par le dispositif de détection de température en tenant compte des signaux de ces cinquième et sixième dispositifs de détection de température (TS5, TS6), qui sont conçus pour détecter pendant le test la température d'entrée (Tin) et la température de sortie (Tout) du fluide (F) fourni au dispositif de serrage (1) pour le refroidissement.

7. Système selon la revendication 6, **caractérisé en ce que** le dispositif de thermorégulation est conçu pour réduire la puissance calorifique (PW) en tenant compte en outre d'une augmentation de température de la zone de puce (CH) détectée au moyen du signal d'un premier dispositif de détection de température (TS1), le premier dispositif de détection de température (TS1) étant conçu pour détecter la température de la zone de puce (CH) sans contact pendant le test.

8. Système selon la revendication 7, **caractérisé en ce que** le premier dispositif de détection de température (TS1) comprend un thermomètre infrarouge (120, 121).

9. Système selon l'une des revendications précédentes 6 à 8, **caractérisé en ce que** le dispositif de serrage (1) comprend une zone supérieure (1a), une zone médiane (1b) et une zone inférieure (1c),la zone supérieure (1a) présentant la surface d'appui (AF) en contact avec la face arrière (R) de la plaquette semi-conductrice (5), la zone médiane (1b) présentant le dispositif de chauffage (HE) et la zone inférieure (1c) présentant le dispositif de refroidissement (11a, 11b, 11c).
